# EUROPÄISCHE PATENTSCHRIFT

(11) **EP 1 251 639 B1**
(45) Veröffentlichungstag und Bekanntmachung des Hinweises auf die Patenterteilung: **03.06.2009**
(21) Anmeldenummer: 02007894.5
(22) Anmeldetag: 09.04.2002
(51) Int. Cl.: H03K 19/003, H03K 19/017

(54) **Elektrische Schaltung**
Electrical circuit
Circuit électrique

(30) Priorität: 18.04.2001 DE 10118863
(43) Veröffentlichungstag der Anmeldung: 23.10.2002
(73) Patentinhaber: Infineon Technologies AG, 81669 München (DE)
(72) Erfinder: Reithofer, Axel, 8020 Graz (AT)
(74) Vertreter: Repkow, Ines

(56) Entgegenhaltungen:
- EP-A- 0 973 261
- US-A- 6 031 403

## Beschreibung

Die vorliegende Erfindung betrifft eine elektrische Schaltung gemäß dem Oberbegriff des Patentanspruchs 1.

Elektrische Schaltungen, die einen Knotenpunkt auf ein bestimmtes Potential ziehen, wenn und so lange der Knotenpunkt nicht anderweitig auf ein anderes Potential gezogen wird, werden benötigt, um das Floaten des Knotenpunktes und/oder einen durch Störsignale hervorgerufenen Wechsel des sich am Knotenpunkt einstellenden Spannungspegels zu verhindern. Dies ist beispielsweise von Bedeutung, wenn es vom Pegel des Knotenpunktes abhängt, wie eine damit in Verbindung stehende elektrische Schaltung oder elektrische Komponente arbeitet.

Ein Bedarf für eine solche elektrische Schaltung besteht beispielsweise bei einer integrierten Schaltung, die abhängig vom Pegel einer von außen an einen bestimmten Eingangsanschluß (Pin) angelegten Spannung arbeitet (beispielsweise in einer ersten Betriebsart arbeitet, wenn an den besagten Pin ein niedriger Spannungspegel angelegt wird, und in einer zweiten Betriebsart arbeitet, wenn an den besagten Pin ein hoher Spannungspegel angelegt wird). Durch die elektrische Schaltung soll verhindert werden, daß es vom Zufall abhängt, wie die integrierte Schaltung arbeitet, wenn an den besagten Pin kein Steuersignal angelegt wird.

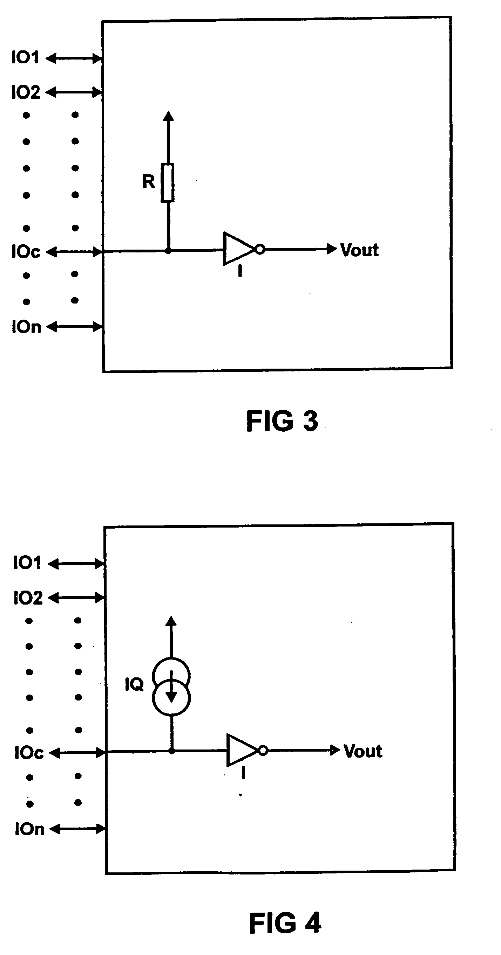

Solche elektrischen Schaltungen sind sogenannte Pull-Up-Schaltungen bzw. Pull-Down-Schaltungen und werden im allgemeinen durch einen Pull-Up- bzw. Pull-Down-Widerstand, oder durch eine Pull-Up- bzw. Pull-Down-Stromquelle gebildet. Der prinzipielle Aufbau solcher elektrischer Schaltungen ist in den Figuren 3 und 4 veranschaulicht.

Die Figur 3 zeigt eine integrierte Schaltung IC mit einer Vielzahl von Ein- und/oder Ausgabeschlüssen IO1, IO2, ... IOn, wobei es vom Pegel einer an einen Eingangsanschluß IOc angelegten Spannung abhängt, wie die integrierte Schaltung arbeitet. Dem Eingangsanschluß sind ein Inverter I und ein Widerstand R vorgeschaltet, wobei der Inverter I die am Eingangsanschluß IOc anliegende Spannung invertiert und weiterleitet, und wobei der Widerstand R den Eingabeanschluß IOc mit einer einen hohen Spannungspegel aufweisenden Stelle verbindet (in diesem Fall wirkt der Widerstand R als Pull-Up-Widerstand) oder mit einer einen niedrigen Spannungspegel aufweisenden Stelle verbindet (in diesem Fall wirkt der Widerstand R als Pull-Down-Widerstand).

Der Widerstand R ist so dimensioniert, daß er den Eingabeanschluß auf den hohen Pegel (Pull-Up-Widerstand) oder den niedrigen Pegel (Pull-Down-Widerstand) zieht, wenn an den Eingangsanschluß IOc von außen keine Spannung angelegt wird, und daß er den Spannungspegel des Eingangsanschlusses IOc im wesentlichen unverändert läßt, wenn an den Eingangsanschluß IOc von außen eine Spannung angelegt wird.

Bei der in der Figur 4 gezeigten Anordnung wird statt des Widerstandes R eine Stromquelle IQ verwendet, die je nach Polung als Pull-Up-Stromquelle oder Pull-Down-Stromquelle wirkt und im Ergebnis die selbe Wirkung entfaltet wie der Widerstand R in der in der Figur 3 gezeigten Anordnung.

Weitere Pull-Up- und Pull-Down-Schaltungen sind aus der EP-A-0 973. 261 und der US-A-6 031 403 bekannt, wobei in der EP-A-0 973 261 eine elektrische Schaltung gemäß dem Oberbegriff des Patentanspruchs 1 beschrieben ist.

Solche und andere Pull-Up- und Pull-Down-Schaltungen weisen das Problem auf, daß es schwierig oder gar unmöglich ist, diese optimal zu dimensionieren. Wird der Eingangsanschluß IOc durch einen kleinen Widerstand R bzw. eine starke Stromquelle IQ stark auf den hohen oder den niedrigen Spannungspegel gezogen, so muß dann, wenn an den Eingangsanschluß von außen der entgegengesetzte Spannungspegel angelegt wird, mit einer hohen Verlustleistung gerechnet werden; wird der Eingangsanschluß IOc durch einen großen Widerstand R bzw. eine schwache Stromquelle IQ schwach auf den hohen oder den niedrigen Spannungspegel gezogen, so kann es passieren, daß Störungen (beispielsweise elektromagnetische Strahlung) zu einer unerwünschten Veränderung des Spannungspegels des Eingangsanschlusses IOc führen.

Der vorliegenden Erfindung liegt daher die Aufgabe zugrunde, die elektrische Schaltung gemäß dem Oberbegriff des Patentanspruchs 1 derart weiterzubilden, daß das Potential, auf welches der Knotenpunkt durch die elektrische Schaltung gezogen wird, durch ein schwaches Signal, nicht aber auch schon durch elektromagnetische Störungen veränderbar ist.

Diese Aufgabe wird erfindungsgemäß durch die im kennzeichnenden Teil des Patentanspruchs 1 beanspruchten Merkmale gelöst.

Die erfindungsgemäße elektrische Schaltung ist dadurch in der Lage, das Potential des Knotenpunktes
- schwach auf das bestimmte Potential zu ziehen, wenn und so lange der Knotenpunkt durch ein externes Signal auf ein anderes Potential gezogen wird, und
- stark auf das bestimmte Potential zu ziehen, wenn und so lange der Knotenpunkt nicht durch ein externes Signal auf ein anderes Potential gezogen wird.

Dadurch kann erreicht werden, daß das Potential, auf welches der Knotenpunkt durch die elektrische Schaltung gezogen wird, durch ein schwaches Signal, nicht aber auch schon durch elektromagnetische Störungen veränderbar ist.

Vorteilhafte Weiterbildungen der Erfindung sind den Unteransprüchen, der folgenden Beschreibung, und den Figuren entnehmbar.

Die Erfindung wird nachfolgend anhand eines Ausführungsbeispiels unter Bezugnahme auf die Figuren näher erläutert. Es zeigen
- Figur 1: zeigt ein Ausführungsbeispiel des prinzipiellen Aufbaus der nachfolgend näher beschriebenen Pull-Up-bzw. Pull-Down-Schaltung,
- Figur 2: eine Möglichkeit zur einfachen praktischen Realisierung der in der Figur 1 gezeigten Schaltung,
- Figur 3: eine eine herkömmliche Pull-Up- bzw. Pull-Down-Schaltung enthaltende Anordnung, und
- Figur 4: eine eine andere herkömmliche Pull-Up- bzw. Pull-Down-Schaltung enthaltende Anordnung.

Die nachfolgend näher beschriebene Pull-Up- bzw. Pull-Down-Schaltung ist Bestandteil einer integrierten Schaltung und dient dazu, einen bestimmten Eingangsanschluß derselben
- auf einen hohen Spannungspegel zu ziehen, wenn und so lange an den betreffenden Eingangsanschluß von außen kein niedriger Spannungspegel angelegt wird, oder
- auf einen niedrigen Spannungspegel zu ziehen, wenn und so lange an den betreffenden Eingangsanschluß von außen kein hoher Spannungspegel angelegt wird.

Es sei jedoch bereits an dieser Stelle darauf hingewiesen, daß die beschriebene Schaltung auch außerhalb einer integrierten Schaltung vorgesehen sein kann, und daß die beschriebene Schaltung auch beliebige andere Knotenpunkte als Ein- und/oder Ausgangsanschlüsse von integrierten Schalungen auf einen hohen oder einen niedrigen Spannungspegel ziehen kann.

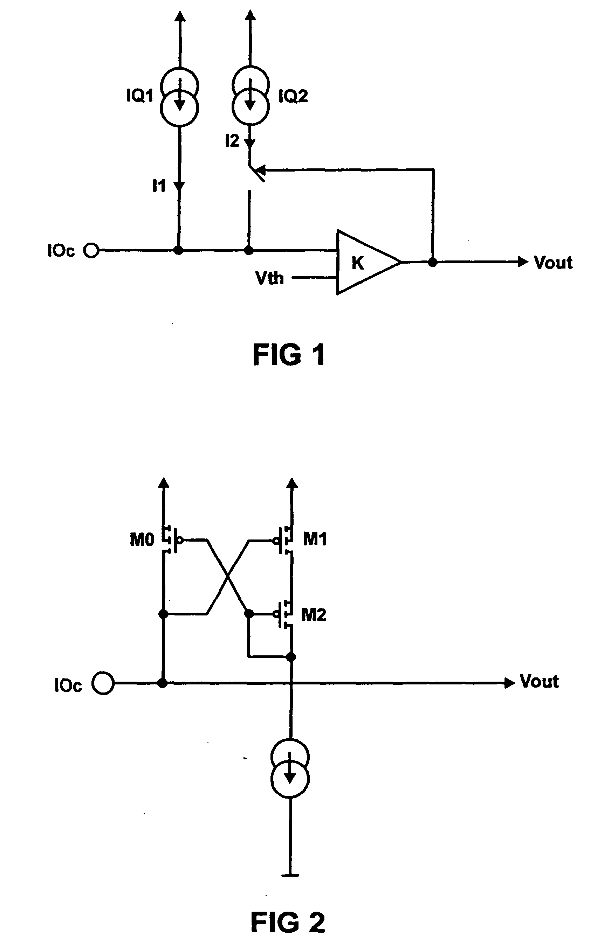

Das Prinzip der betrachteten Schaltung ist in Figur 1 veranschaulicht.

Die in der Figur 1 gezeigte Schaltung dient dazu, einen Eingangsanschluß IOc der die Schaltung enthaltenden integrierten Schaltung auf einen hohen oder einen niedrigen Spannungspegel zu ziehen, wenn und so lange an den betreffenden Eingangsanschluß von außen kein niedriger bzw. kein hoher Spannungspegel angelegt wird. Die gezeigte Schaltung umfaßt
- eine mit dem Eingangsanschluß IOc verbundene erste Stromquelle IQ1,
- eine über einen Schalter S mit dem Eingangsanschluß IOc verbundene zweite Stromquelle IQ2, wobei geöffnet ist, wenn ein ihn steuerndes Signal einen niedrigen Spannungspegel aufweist, und wobei der Schalter geschlossen ist, wenn das ihn steuernde Signal einen hohen Spannungspegel aufweist (oder umgekehrt), und
- einen Komparator K, der den sich am Eingangsanschluß IOc einstellenden und einem ersten Eingangsanschluß des Komparators zugeführten Spannungspegel und eine einem zweiten Eingangsanschluß des Komparators zugeführte Schwellenspannung Vₜₕ vergleicht, und dessen das Vergleichsergebnis repräsentierende Ausgangssignal zur Steuerung des Schalters S verwendet und an die Komponenten der integrierten Schaltung, die abhängig von dem sich am Eingangsanschluß IOc einstellenden Spannungspegel arbeiten, weitergeleitet wird.

Die in der Figur 1 gezeigte Schaltung funktioniert für den Fall, daß es sich um eine Pull-Up-Schaltung handelt, wie folgt:
Die Pull-Up-Schaltung zieht den Eingangsanschluß IOc auf einen hohen Spannungspegel, wenn und so lange an den Eingangsanschluß von außen keine Spannung mit niedrigem Pegel angelegt wird.

Wenn an den Eingangsanschluß IOc von außen ein niedriger Spannungspegel angelegt wird, wird das sich dadurch am Eingangsanschluß IOc einstellende Potential nach unten gezogen. Wenn das sich dadurch am Eingangsanschluß IOC einstellende Potential niedriger als die Schwellenspannung Vₜₕ ist, weist das Ausgangssignal des Komparators einen den Schalter S öffnenden oder offen haltenden (niedrigen) Pegel auf, wodurch der sich am Eingangsanschluß IOc einstellende Spannungspegel nur durch die erste Stromquelle IQ1 nach oben gezogen werden kann. Der von der ersten Stromquelle IQ1 gelieferte Strom I1 ist jedoch so schwach, daß der sich am Eingangsanschluß IOc einstellende Spannungspegel nicht oder nur unwesentlich nach oben gezogen wird, und daß die durch das Fließen des Stromes I1 hervorgerufene Verlustleistung sehr gering ist.

Wenn an den Eingangsanschluß IOc von außen keine Spannung angelegt wird, wird das sich am Eingangsanschluß IOc einstellende Potential durch die erste Stromquelle IQ1 nach oben gezogen. Wenn das sich dadurch am Eingangsanschluß IOc einstellende Potential die Schwellenspannung Vₜₕ übersteigt, weist das Ausgangssignal des Komparators einen den Schalter S schließenden (hohen) Pegel auf, wodurch die sich am Eingangsanschluß IOc einstellende Spannung zusätzlich auch durch die zweite Stromquelle IQ2 nach oben gezogen wird. Die Summe des von der ersten Stromquelle IQ1 gelieferten Stromes I1 und des von der zweiten Stromquelle IQ2 gelieferten Stromes I2 ist so groß, daß der sich am Eingangsanschluß IOc einstellende Spannungspegel so stark nach oben gezogen wird, daß Störsignale wie beispielsweise elektromagnetische Strahlung keine Chance haben, die sich am Eingangsanschluß IOc einstellende Spannung auf eine einen niedrigen Spannungspegel repräsentierende Spannung zu ziehen.

Die Pull-Up-Schaltung zieht nach alledem die sich am Eingangsanschluß IOc einstellende Spannung
- zu Zeiten, zu welches es vorteilhaft ist, diese schwach nach oben zu ziehen, schwach nach oben, und
- zu Zeiten, zu welches es vorteilhaft ist, diese stark nach oben zu ziehen, stark nach oben.

Für den Fall, daß es sich bei der in der Figur 1 gezeigten Schaltung um eine Pull-Down-Schaltung handelt, funktioniert diese wie folgt:
Die Pull-Down-Schaltung zieht den Eingangsanschluß IOc auf einen niedrigen Spannungspegel, wenn und so lange an den Eingangsanschluß von außen keine Spannung mit hohem Pegel angelegt wird.

Wenn an den Eingangsanschluß IOc von außen ein hoher Spannungspegel angelegt wird, wird das sich dadurch am Eingangsanschluß IOc einstellende Potential nach oben gezogen. Wenn das sich dadurch am Eingangsanschluß IOc einstellende Potential größer als die Schwellenspannung Vₜₕ ist, weist das Ausgangssignal des Komparators einen den Schalter S öffnenden oder offen haltenden (hohen) Pegel auf, wodurch der sich am Eingangsanschluß IOc einstellende Spannungspegel nur durch die erste Stromquelle IQ1 nach unten gezogen werden kann. Der von der ersten Stromquelle IQ1 gelieferte Strom I1 ist jedoch so schwach, daß der sich am Eingangsanschluß IOc einstellende Spannungspegel nicht oder nur unwesentlich nach unten gezogen wird, und daß die durch das Fließen des Stromes I1 hervorgerufene Verlustleistung sehr gering ist.

Wenn an den Eingangsanschluß IOc von außen keine Spannung angelegt wird, wird das sich am Eingangsanschluß IOc einstellende Potential durch die erste Stromquelle IQ1 nach unten gezogen. Wenn das sich dadurch am Eingangsanschluß IOc einstellende Potential die Schwellenspannung Vₜₕ unterschreitet, weist das Ausgangssignal des Komparators einen den Schalter S schließenden der geschlossen haltenden (niedrigen) Pegel auf, wodurch die sich am Eingangsanschluß IOc einstellende Spannung zusätzlich auch durch die zweite Stromquelle IQ2 nach unten gezogen wird. Die Summe des von der ersten Stromquelle IQ1 gelieferten Stromes I1 und des von der zweiten Stromquelle IQ2 gelieferten Stromes I2 ist so groß, daß die sich am Eingangsanschluß IOc einstellende Spannung so stark nach unten gezogen wird, daß Störsignale wie beispielsweise elektromagnetische Strahlung keine Chance haben, die sich am Eingangsanschluß IOc einstellende Spannung auf eine einen hohen Spannungspegel repräsentierende Spannung zu ziehen.

Die Pull-Down-Schaltung zieht nach alledem die sich am Eingangsanschluß IOc einstellende Spannung
- zu Zeiten, zu welchen es vorteilhaft ist, diese schwach nach unten zu ziehen, schwach nach unten, und
- zu Zeiten, zu welchen es vorteilhaft ist, diese stark nach unten zu ziehen, stark nach unten.

Als Stromquellen IQ1 und IQ2 können MOS-Transistoren oder Bipolar-Transistoren verwendet werden. Anstelle der Stromquellen können auch Widerstände zum Einsatz kommen über welche der Eingangsanschluß IOc mit einer Spannungsquelle verbunden wird.

Es könnte auch vorgesehen werden, anstelle der zwei parallel geschalteten Pull-Elemente nur ein einziges Pull-Element zu verwenden und dieses so anzusteuern oder so zu verschalten, daß es die sich am Eingangsanschluß IOc einstellende Spannung abhängig von dieser Spannung schwach oder stark nach oben bzw. nach unten zieht.

Darüber hinaus könnte auch vorgesehen werden, auf den Komparator K zu verzichten.

Eine mögliche praktische Realisierung einer abhängig vom Potential des Eingangsanschlusses IOc arbeitenden Pull-Up-Schaltung ist in Figur 2 veranschaulicht.

Die in der Figur 2 gezeigte Pull-Up-Schaltung umfaßt
- einen ersten PMOS-Transistor M0, dessen Drain-Anschluß mit dem Eingangsanschluß IOc verbunden ist, dessen Source-Anschluß mit einer positiven Spannung beaufschlagt wird, und dessen Gate-Anschluß mit dem Ausgangssignal einer Steuereinrichtung verbunden ist, und
- die den Transistor M0 steuernde Steuereinrichtung, wobei diese Steuereinrichtung aus einem zweiten PMOS-Transistor M1, einem dritten PMOS-Transistor M2 und einer Stromquelle IQ3 besteht, und wobei
   - der zweite Transistor M1, der dritte Transistor M2 und die Stromquelle IQ in Reihe geschaltet sind,
   - vom zweiten Transistor M1 der Source-Anschluß mit einer positiven Spannung beaufschlagt wird, der Drain-Anschluß mit dem Source-Anschluß des dritten Transistors M2 verbunden ist, und der Gate-Anschluß mit den Eingangsanschluß IOc verbunden ist,
   - vom dritten Transistor M2 der Source-Anschluß mit dem Drain-Anschluß des zweiten Transistors M1 verbunden ist, und der Drain-Anschluß und der Gate-Anschluß jeweils mit dem einen Pol der Stromquelle IQ und dem Gate-Anschluß des ersten Transistors M0 verbunden sind, und
   - von der Stromquelle IQ der eine Pol mit dem Drain-Anschluß des dritten Transistors M2, mit dem Gate-Anschluß des dritten Transistors M2, und mit dem Gate-Anschluß des ersten Transistors M0 verbunden ist, und der zweite Pol mit Masse verbunden ist.

Wenn an den Eingangsanschluß IOc von außen eine niedrige Spannung (Massepotential) angelegt wird, stellt sich am zweiten Transistor M1 eine große Gate-Source-Spannung U_{GS} ein (U_{GS} entspricht der Versorgungsspannung) und zieht die Stromquelle IQ3 einen kleinen (Bias-)Strom. Dies hat zur Folge, daß sich am zweiten Transistor M1 eine Drain-Source-Spannung U_{DS} einstellt, die, weil die Gate-Source-Spannung U_{GS} vom M1 sehr groß ist und M1 im Widerstandsbereich arbeitet, vernachlässigbar gering ist. Dadurch arbeiten die Transistoren M2 und M0 als Stromspiegel, der den statischen Stromverbrauch bestimmt, wobei das Spiegelverhältnis und der statische Stromverbrauch frei wählbar sind.

Wenn an den Eingangsanschluß IOc von außen keine Spannung angelegt wird, zieht der Transistor M0 das floatende Potential des Eingangsanschlusses IOc nach oben. Dadurch verringert sich die Gate-Source-Spannung U_{GS} von Transistor M1, und vergrößert sich die Drain-Source-Spannung U_{DS} von Transistor M1. Dies wiederum hat zu Folge, daß sich die Gate-Source-Spannung U_{GS} des Transistors M0 erhöht, wodurch wiederum das Potential des Eingangsanschlusses IOc, und damit auch die am Gate-Anschluß von M1 anliegende Spannung noch weiter nach oben gezogen werden. Schließlich sperrt M1, und wird der Gate-Anschluß der Transistoren M0 und M2 von der Stromquelle IQ3 auf Massepotential gezogen. In diesem Zustand arbeitet der Transistor M0 im Widerstandsbereich und läßt den maximal möglichen Strom passieren, welcher sich über das sogenannte W/L-Verhältnis des Transistors M0 einstellen läßt.

Zieht man in diesem Zustand aus dem Eingangsanschluß IOc (durch Anlegen einer niedrigen Spannung) einen Strom heraus, sinkt das sich am Eingangsanschluß IOc einstellende Potential, wodurch die Schaltung schließlich zum Kippen bzw. Umschalten gebracht wird, und die Transistoren M0 und M2 wieder als Stromspiegel arbeiten und nur relativ geringe Ströme fließen.

Bei der in der Figur 2 gezeigten Pull-Up-Schaltung sind der statische Stromverbrauch und die Störanfälligkeit beliebig und unabhängig voneinander über das Flächenverhältnis der einzelnen Transistoren dimensionierbar.

Die Schwellenspannung Vₜₕ, in Abhängigkeit von welcher die in der Figur 1 gezeigte Schaltung zum Umschalten gebracht wird, ist bei der Schaltung gemäß Figur 2 die Spannung, die die darin enthaltene Kreuzkopplungsschaltung zum Kippen bringt, und kann ebenfalls über das Flächenverhältnis der Transistoren definiert werden.

Die Schaltung muß so dimensioniert sein, daß der statische Strom groß genug ist, um das Potential, das sich im floatenden Zustand des Eingangsanschlusses IOc an diesem einstellt, über die Schwellenspannung Vₜₕ zu ziehen. Dabei ist zu berücksichtigen, daß der floatende Eingangsanschluß IOc über parasitäre Widerstände (beispielsweise über Kriechstrecken) mit dem Masseanschluß einer die integrierte Schaltung tragenden Leiterplatte verbunden sein kann. Der Wert dieses parasitären Widerstandes beträgt den Angaben einiger Hersteller zufolge zwischen 50 kΩ und 100 kΩ.

Der in der Figur 2 gezeigten Schaltung wird vorzugsweise ein Inverter nachgeschaltet. Dieser Inverter ist vorzugsweise so dimensioniert, daß seine Schaltschwelle unter Vth liegt. Dadurch kann erreicht werden, daß ein Störimpuls das Potential des Eingangsanschlusses bis Vth nach unten ziehen kann, ohne daß diese Störung am Ausgang des Inverters sichtbar wird.

Die Realisierung einer Pull-Down-Schaltung erfolgt analog; es sind nur die Polaritäten der Spannungen zu vertauschen, und NMOS-Transistoren statt PMOS-Transistoren zu verwenden.

Es dürfte einleuchten, daß es unzählige weitere Möglichkeiten gibt, um eine Pull-Up-Schaltung oder eine Pull-Down-Schaltung zu realisieren, die abhängig von dem Potential arbeiten, welches sie nach oben oder unten ziehen sollen.

Die beschriebenen elektrischen Schaltungen ermöglichen es unabhängig von den Einzelheiten der praktischen Realisierung, daß das Potential, auf welches der Knotenpunkt durch die elektrische Schaltung gezogen wird, durch ein schwaches Signal, nicht aber auch schon durch elektromagnetische Störungen veränderbar ist.

### Bezugszeichenliste

- I: Inverter
- IC: integrierte Schaltung
- IOx: Ein- und/oder Ausgabeanschlüsse von IC
- Iqx: Stromquellen
- K: Komparator
- R: Widerstand
- S: Schalter
- Vth: Schwellenspannung

## Patentansprüche

1. Elektrische Schaltung, die einen Knotenpunkt (IOc) auf ein bestimmtes Potential zieht, wenn und so lange der Knotenpunkt nicht anderweitig auf ein anderes Potential gezogen wird,
- wobei die elektrische Schaltung abhängig von dem sich am Knotenpunkt einstellenden Potential arbeitet,
- wobei die elektrische Schaltung eine Komponente (M0) enthält, welche den Knotenpunkt (IOc) mit dem Potential beaufschlagt, auf welches der Knotenpunkt durch die elektrische Schaltung zu bringen ist,
- wobei die Komponente eine steuerbare Komponente ist, wobei durch die Ansteuerung der Komponente einstellbar ist, wie stark der Knotenpunkt (IOc) auf das bestimmte Potential gezogen wird, und
- wobei die steuerbare Komponente durch einen Transistor (M0) gebildet wird, dessen Drain-Anschluß mit dem Knotenpunkt (IOc) verbunden ist, dessen Source-Anschluß mit einer Spannung beaufschlagt wird, die etwa dem Potential entspricht, auf welches der Knotenpunkt zu bringen ist, und dessen Gate-Anschluß mit dem Ausgangssignal einer Steuereinrichtung verbunden ist,
**dadurch gekennzeichnet,**
**daß** die Steuereinrichtung einen zweiten Transistor (M1), einen dritten Transistor (M2), und eine Stromquelle (IQ3) umfaßt, wobei
- der zweite Transistor (M1), der dritte Transistor (M2) und die Stromquelle (IQ3) in Reihe geschaltet sind,
- vom zweiten Transistor (M1) der Source-Anschluß mit einem Pol der die Steuereinrichtung mit Energie versorgenden Versorgungsspannung verbunden ist, der Drain-Anschluß mit dem Source-Anschluß des dritten Transistors (M2) verbunden ist, und der Gate-Anschluß mit dem Knotenpunkt (IOc) verbunden ist,
- vom dritten Transistor (M2) der Source-Anschluß mit dem Drain-Anschluß des zweiten Transistors (M1) verbunden ist, und der Drain-Anschluß und der Gate-Anschluß jeweils mit dem einen Pol der Stromquelle (IQ3) und dem Gate-Anschluß des ersten Transistors (M0) verbunden sind, und
- von der Stromquelle (IQ3) der eine Pol mit dem Gate-Anschluß und dem Drain-Anschluß des dritten Transistors (M2), und mit dem Gate-Anschluß des ersten Transistors (M0) verbunden ist, und der zweiten Pol mit dem anderen Pol der die Steuereinrichtung mit Energie versorgenden Versorgungsspannung verbunden ist.

2. Elektrische Schaltung nach Anspruch 1,
**dadurch gekennzeichnet,**
**daß** die elektrische Schaltung eine Pull-Up-Schaltung.ist, welche den Knotenpunkt (IOc) auf den hohen Spannungspegel zieht, wenn und so lange er nicht anderweitig auf einen niedrigeren Spannungspegel gezogen wird.

3. Elektrische Schaltung nach Anspruch 1,
**dadurch gekennzeichnet,**
**daß** die elektrische Schaltung eine Pull-Down-Schaltung ist, welche den Knotenpunkt (IOc) auf den niedrigen Spannungspegel zieht, wenn und so lange er nicht anderweitig auf einen höheren Spannungspegel gezogen wird.

4. Elektrische Schaltung nach einem der vorhergehenden Ansprüche,
**dadurch gekennzeichnet,**
**daß** die elektrische Schaltung Bestandteil einer integrierten Schaltung (IC) ist, und daß der Knotenpunkt (IOc) mit einem Eingabeanschluß der integrierten Schaltung verbunden ist.

## Claims

1. Electrical circuit, which draws a node point (IOc) to a specific potential when and for as long as the node point is not drawn in any other way to a different potential,
- with the electrical circuit operating as a function of the potential at the node point,
- with the electrical circuit containing a component (M0) which connects the node point (IOc) to the potential to which the node point is to be brought by the electrical circuit,
- with the component being a controllable component, in which case, by driving the component, it is possible to select how strongly the node point (IOc) is drawn to the specific potential, and
- with the controllable component being formed by a transistor (M0) whose drain connection is connected to the node point (IOc), whose source connection has a voltage applied to it which corresponds approximately to the potential to which the node point is to be brought, and whose gate connection is connected to the output signal from a control device,
**characterized**
**in that** the control device comprises a second transistor (M1), a third transistor (M2) and a current source (IQ3) with
- the second transistor (M1), the third transistor (M2) and the current source (IQ3) being connected in series,
- the source connection of the second transistor (M1) being connected to one pole of the supply voltage which supplies power to the control device, its drain connection being connected to the source connection of the third transistor (M2), and its gate connection being connected to the node point (IOc),
- the source connection of the third transistor (M2) being connected to the drain connection of the second transistor (M1) and its drain connection and gate connection respectively being connected to one pole of the current source (IQ3) and to the gate connection of the first transistor (M0), and
- one pole of the current source (IQ3) being connected to the gate connection and to the drain connection of the third transistor (M2), and being connected to the gate connection of the first transistor (M0), and its second pole being connected to the other pole of the supply voltage which supplies power to the control device.

2. Electrical circuit according to Claim 1,
**characterized**
**in that** the electrical circuit is a pull-up circuit, which draws the node point (IOc) to the high voltage level when and for as long as it is not drawn in some other way to a lower voltage level.

3. Electrical circuit according to Claim 1,
**characterized**
**in that** the electrical circuit is a pull-down circuit, which draws the node point (IOc) to the low voltage level when and for as long as it is not drawn in any other way to a higher voltage level.

4. Electrical circuit according to one of the preceding claims,
**characterized**
**in that** the electrical circuit is part of an integrated circuit (IC), and in that the node point (IOc) is connected to an input connection of the integrated circuit.

## Revendications

1. Circuit électrique qui tire un point de noeud (IOc) vers un potentiel défini si et aussi longtemps que le point de noeud n'est pas tiré d'une autre manière vers un autre potentiel,
le circuit électrique travaillant en fonction du potentiel établi au point de noeud,
le circuit électrique contenant un composant (M0) qui applique sur le point de point de noeud (IOc) le potentiel auquel le point de noeud doit être amené par le circuit électrique,
le composant étant un composant asservi, la commande du composant permettant d'établir la force avec laquelle le point de noeud (IOc) est tiré vers le potentiel défini et
le composant asservi étant formé par un transistor (M0) dont la borne de drain est reliée au point de noeud (IOc), dont la borne de source reçoit une tension qui correspond sensiblement au potentiel auquel le point de noeud doit être amené et dont la borne de grille est reliée au signal de sortie d'un dispositif de commande,
**caractérisé en ce que**
le dispositif de commande comporte un deuxième transistor (M1), un troisième transistor (M2) et une source de courant (IQ3),
le deuxième transistor (M1), le troisième transistor (M2) et la source de courant (IQ3) étant raccordés en série,
la borne de source du deuxième transistor (M1) étant reliée à un pôle de la tension d'alimentation qui alimente en énergie le dispositif de commande, sa borne de drain étant reliée à la borne de source du troisième transistor (M2) et sa borne de grille étant reliée au point de noeud (IOc),
la borne de source du troisième transistor (M2) étant reliée à la borne de drain du deuxième transistor (M1), la borne de drain et la borne de grille étant reliées respectivement à un des pôles de la source de courant (IQ3) et à la borne de grille du premier transistor (M0) et
un des pôles de source de courant (IQ3) étant relié à la borne de grille et à la borne de drain du troisième transistor (M2) ainsi qu'à la borne de grille du premier transistor (M0), le deuxième pôle étant relié à l'autre pôle de la tension d'alimentation qui alimente en énergie le dispositif de commande.

2. Circuit électrique selon la revendication 1, **caractérisé en ce que** le circuit électrique est un circuit de relèvement, dit "pull-up", qui tire le point de noeud (IOc) vers un niveau de tension haut si et aussi longtemps qu'il n'est pas tiré d'une autre manière vers un niveau de tension plus bas.

3. Circuit électrique selon la revendication 1, **caractérisé en ce que** le circuit électrique est un circuit d'abaissement, dit "pull-down", qui tire le point de noeud (IOc) vers un bas niveau de tension si et aussi longtemps qu'il n'est pas tiré d'une autre manière vers un niveau de tension plus haut.

4. Circuit électrique selon l'une des revendications précédentes, **caractérisé en ce que** le circuit électrique fait partie d'un circuit intégré (IC) et **en ce que** le point de noeud (IOc) est relié à une borne d'entrée du circuit intégré.
